# EUROPEAN PATENT APPLICATION

(11) **EP 2 978 028 A1**
(43) Date of publication of application: **27.01.2016**
(21) Application number: 14769613.2
(22) Date of filing: 14.03.2014
(51) Int. Cl.: H01L 31/0747, H01L 31/20

(54) **PHOTOVOLTAIC DEVICE**

(30) Priority: 19.03.2013 JP 2013056713
(71) Applicant: Choshu Industry Co., Ltd., Sanyo-onoda-shi, Yamaguchi 757-8511 (JP)
(72) Inventor: KOBAYASHI Eiji, Sanyo-onoda-shi Yamaguchi 757-8511 (JP)
(74) Representative: von Kreisler Selting Werner - Partnerschaft von Patentanwälten und Rechtsanwälten mbB
(86) International application number: PCT/JP2014/056939
(87) International publication number: WO 2014/148392

(57) **Abstract**

Provided is a photo-electric power generating device having a great fill factor. A photo-electric power generating device 10 including: a multilayered photo-electric power generating element 11; a first collector member 12 overlaid on one face of the photo-electric power generating element 11; and a second collector member 13 overlaid on other face of the photo-electric power generating element 11, the photo-electric power generating element 11 including: an n-type crystal semiconductor substrate 14; a first intrinsic amorphous silicon thin film 15, a p-type amorphous silicon thin film 16 and a first transparent conductive film 17 overlaid in this order on the side provided with the first collector member 12 on the n-type crystal semiconductor substrate 14; and an n-type amorphous silicon thin film 19 and a second transparent conductive film 20 overlaid in this order on the side provided with the second collector member 13 on the n-type crystal semiconductor substrate 14, in which the p-type amorphous silicon thin film 16 has a thickness of less than 6 nm, and the maximum width of the nonoverlaid region 25 of the first collector member 12 on the surface of the first transparent conductive film 17 is less than 2 mm.

## Description

### [Technical Field]

The present invention relates to a photo-electric power generating device, and more specifically, relates to a photo-electric power generating device having heterojunctions (solar cell).

### [Background Art]

As a clean electric power generation means not accompanied by generation of greenhouse gas such as CO₂, and as an electric power generation means that may replace nuclear electric power generation and that is highly operationally safe, photo-electric power generating devices have attracted attention. One of the photo-electric power generating devices is a photo-electric power generating device having heterojunctions that exhibits superior efficiency of electric power generation.

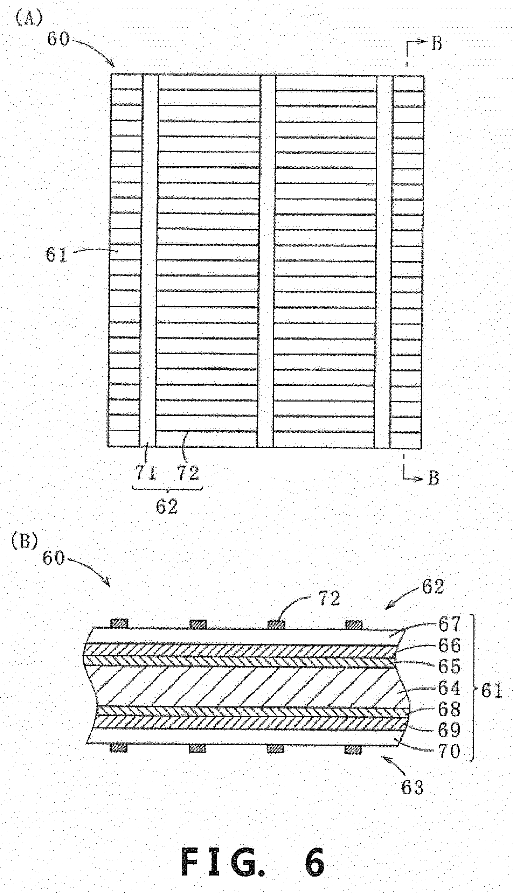

As shown in FIGs. 6 (A) and (B), the photo-electric power generating device 60 having heterojunctions includes: a photo-electric power generating element 61 that generates electric power by irradiation with light; and collector members 62, 63 that are each provided on both two faces of the photo-electric power generating element 61 and collect the generated electric power. The photo-electric power generating element 61 is a multilayer structure formed by: overlaying a first intrinsic amorphous silicon thin film 65, a p-type amorphous silicon thin film 66 and a first transparent conductive film 67 in this order on one side of an n-type crystal semiconductor substrate 64; and overlaying a second intrinsic amorphous silicon thin film 68, an n-type amorphous silicon thin film 69 and a second transparent conductive film 70 in this order on the other side of the n-type crystal semiconductor substrate 64. Accordingly, by thus providing the first intrinsic amorphous silicon thin film 65 between the n-type crystal semiconductor substrate 64 and the p-type amorphous silicon thin film 66, carrier recombination that occurs between the n-type crystal semiconductor substrate 64 and the p-type amorphous silicon thin film 66 can be inhibited, and by providing the second intrinsic amorphous silicon thin film 68 between the n-type crystal semiconductor substrate 64 and the n-type amorphous silicon thin film 69, carrier recombination which may occur between these can be inhibited similarly. In addition, the collector member 62 (63) has a plurality of busbar electrodes 71 formed to be parallel with each other, and a plurality of finger electrodes 72 connected to the busbar electrode 71 and formed to be parallel with each other. By way of the collector member 62 (63) having such a structure, efficient current collection is carried out while light shielding by a collector member itself is inhibited.

In the photo-electric power generating device 60 having such a structure, it is reportedly preferred to make the thickness of the p-type amorphous silicon thin film 66 great, specifically no less than 6 nm, for example (see Patent Document 1). The first transparent conductive film 67 overlaid on the p-type amorphous silicon thin film 66 is typically formed by sputtering. Thus, by using the p-type amorphous silicon thin film 66 having a certain level of thickness, deterioration of the surface resulting from sputtering is reportedly prevented, and deterioration of performances of the photo-electric power generating device 60 can be reportedly inhibited. However, since electric power generation that is efficient at lower cost has been demanded for photo-electric power generating devices in these days, further improvement for increasing a fill factor has been expected.

### [Prior Art Documents]

### [Patent Documents]

Patent Document 1: Japanese Patent No. 5031007

### [SUMMARY OF THE INVENTION]

### [Problems to be Solved by the Invention]

The present invention was made in view of such circumstances, and it is an object of the present invention to provide a photo-electric power generating device that leads to a high fill factor.

### [Means for Solving the Problems]

The present inventor found that: (1) an increase of the thickness of a p-type amorphous silicon thin film results in an increase in series resistance, thereby leading to a decrease of the fill factor to the contrary; (2) a decrease in the thickness of the p-type amorphous silicon thin film, and a decrease of intervals and the like of finger electrodes provided on the side of the p-type amorphous silicon thin film are effective for increasing the fill factor; and (3) a decrease of the intervals of the finger electrodes provided on the side of an n-type amorphous silicon thin film does not result in an improvement of the fill factor to the contrary, and consequently accomplished the present invention based on these findings.

More specifically, the photo-electric power generating device according to an aspect of the present invention that attains the aforementioned object includes:
a multilayered photo-electric power generating element; a first collector member overlaid on one face of the photo-electric power generating element; and a second collector member overlaid on other face of the photo-electric power generating element,
the photo-electric power generating element including: an n-type crystal semiconductor substrate; a first intrinsic amorphous silicon thin film, a p-type amorphous silicon thin film and a first transparent conductive film overlaid in this order on the side provided with the first collector member on the n-type crystal semiconductor substrate; and an n-type amorphous silicon thin film and a second transparent conductive film overlaid in this order on the side provided with the second collector member on the n-type crystal semiconductor substrate,
   in which
the p-type amorphous silicon thin film has a thickness of less than 6 nm, and
a maximum width of the nonoverlaid region of the first collector member on the surface of the first transparent conductive film is less than 2 mm.

According to the photo-electric power generating device of the aspect of the present invention, the thickness of the p-type amorphous silicon thin film being as small as less than 6 nm, and the maximum width of the nonoverlaid region of the first collector member on the surface of the first transparent conductive film (for example, the interval of the finger electrodes) of the photo-electric power generating element being as small as less than 2 mm lead to an increase in the fill factor, and the efficiency of electric power generation can be enhanced. In addition, the second collector member on the side provided with the n-type amorphous silicon thin film may have an arbitrary shape. Thus, variation of usage can be broadened since, for example, the light blocking effect can be impaired through increasing the interval of the second collector members (finger electrodes and the like the on side provided with the n-type amorphous silicon thin film), and the efficiency of electric power generation can be enhanced through serving as a plane of light incidence, a side provided with the second collector member (n-type amorphous silicon thin film).

In the photo-electric power generating device according to the aspect of the present invention, the first transparent conductive film is preferably formed by an ion plating process. When the first transparent conductive film overlaid on the p-type amorphous silicon thin film is formed by an ion plating process, deterioration of the p-type amorphous silicon thin film surface can be inhibited. Therefore, this procedure enables the p-type amorphous silicon thin film having favorable qualities maintained to be used, and the fill factor can be further increased.

In the photo-electric power generating device according to the aspect of the present invention, the thickness of the p-type amorphous silicon thin film is preferably no less than 1 nm. When the p-type amorphous silicon thin film has a thickness of no less than 1 nm, for example, generation of defects can be inhibited, and thus the fill factor can be further increased.

In the photo-electric power generating device according to the aspect of the present invention, it is preferred that the second collector member has a plurality of busbar electrodes (II) formed to be parallel with each other, and a plurality of finger electrodes (II) connected to the busbar electrode (II) and formed to be parallel with each other, and that the interval of the finger electrodes (II) is greater than 2 mm. By thus increasing the interval of the finger electrodes (II) to impair the light blocking effect, the efficiency of electric power generation can be enhanced in a case where the side provided with the second collector member serves as a plane of light incidence.

In the photo-electric power generating device according to the aspect of the present invention, it is preferred that the first collector member has a plurality of busbar electrodes (I) formed to be parallel with each other, and a plurality of finger electrodes (I) connected to the busbar electrode (I) and formed to be parallel with each other, and that the interval of the finger electrodes (I) is identical to the maximum width of the nonoverlaid region. By thus forming the first collector member from the busbar electrodes and the finger electrodes, the production efficiency can be enhanced.

In the photo-electric power generating device according to the aspect of the present invention, it is also preferred that the first collector member is a metal film (i.e., the maximum width of the nonoverlaid region of the first collector member being 0 mm). Accordingly, the electric conductivity, and in turn, the current collection efficiency, of the first collector member can be further enhanced. Moreover, in this instance, sufficient electric conductivity and the like can be attained even if the metal film is made thinner; therefore, as a result, a decrease of the amount of the metal material used for forming the metal film (collector member) is also enabled.

In the photo-electric power generating device according to the aspect of the present invention, the metal film has a thickness of preferably no less than 100 nm and less than 500 nm. When the thickness of the metal film falls within the above range, the manufacturing cost can be reduced while sufficient electric conductivity and the like are attained.

In the photo-electric power generating device according to the aspect of the present invention, the side provided with the second collector member is preferably employed as a plane of light incidence. In the photo-electric power generating device according to the aspect of the present invention, the second collector member may have an arbitrary structure as described above. Thus, the light blocking effect can be impaired through increasing the interval of the finger electrodes in the second collector member, and the efficiency of electric power generation can be enhanced by employing as a plane of light incidence, the side provided with the second collector member.

Alternatively, in the photo-electric power generating device according to the aspect of the present invention, the side provided with the first collector member may be employed as a plane of light incidence. In the photo-electric power generating device according to the aspect of the present invention, the thickness of the p-type amorphous silicon thin film is so small that the ratio of light that passes through the p-type amorphous silicon thin film can be increased in a case where the side provided with the first collector member is employed as a plane of light incidence.

The photo-electric power generating device according to the aspect of the present invention may have a second intrinsic amorphous silicon thin film overlaid between the n-type crystal semiconductor substrate and the n-type amorphous silicon thin film. By overlaying the second intrinsic amorphous silicon thin film between the n-type crystal semiconductor substrate and the n-type amorphous silicon thin film, recombination of the carriers can be inhibited.

In the photo-electric power generating device according to the aspect of the present invention, the n-type crystal semiconductor substrate is preferably produced by an epitaxy process. When the n-type crystal semiconductor substrate produced by an epitaxy process is used, output characteristics such as maximum output of the photo-electric power generating device, and uniformity thereof can be improved.

In the photo-electric power generating device according to the aspect of the present invention, it is preferred that the resistivity of the n-type crystal semiconductor substrate is no less than 0.5 Ωcm and no greater than 5 Ωcm. When the n-type crystal semiconductor substrate having a resistivity falling within the above range is used, maximum output and the like can be increased.

In the photo-electric power generating device according to the aspect of the present invention, a thickness of the n-type crystal semiconductor substrate is preferably no less than 50 µm and no greater than 200 µm, and more preferably no less than 80 µm and no greater than 150 µm. When the substrate thus has a comparatively small thickness, miniaturization of the element itself, and cost reduction can be achieved while sufficient output characteristics are achieved.

With respect to the term "maximum width of a nonoverlaid region" as referred to herein, provided that a position that is present in the nonoverlaid region and that is situated farthest away from the external margin of the nonoverlaid region is defined as "point P", the term "maximum width of a nonoverlaid region" means a length twice the minimum distance between the point P and the external margin of the nonoverlaid region. For example: in a case where the nonoverlaid region is rectangular, the maximum width is the length of a shorter side; in a case where the nonoverlaid region is circular, the maximum width is a diameter; and in a case where the nonoverlaid region is triangular, the maximum width is a diameter of the inscribed circle. Whereas, in a case where the nonoverlaid region is absent, i.e., in a case where the member is overlaid on the entire face, the maximum width is 0 mm. The term "intrinsic" in the "intrinsic amorphous silicon thin film" as referred to herein means that an impurity is not intentionally doped, and involves the state in which impurities originally contained in the basic material, and/or impurities unintentionally incorporated in the manufacturing step are present. The term "amorphous" as referred to means not only amorphous but also microcrystalline inclusively. The term "plane of light incidence" as referred to means a face that is positioned on the side opposing to a light source such as sunlight in use (in general, external side), and thus that is on the side at which the light enters substantially, but a construction such that the light enters also from the reverse face to the plane of light incidence is also acceptable.

### [Effects of the Invention]

The photo-electric power generating device according to the aspect of the present invention leads to a high fill factor, and thus the efficiency of electric power generation can be enhanced.

### [BRIEF DESCRIPTION OF THE DRAWINGS]

FIG. 1 (A) shows a plan view illustrating a photo-electric power generating device according to a first embodiment of the present invention, and FIG. 1 (B) shows a cross sectional view taken in the direction of arrows A-A in FIG. 1 (A);
FIG. 2 shows a graph illustrating results of measurements in Examples 1 to 3 and Comparative Examples 1 and 2;
FIG. 3 shows a graph illustrating results of measurements in Examples 4 and 5;
FIG. 4 shows a cross sectional view illustrating a photo-electric power generating device according to a second embodiment of the present invention;
FIG. 5 shows a schematic view illustrating a method for measuring the film thickness of an amorphous silicon thin film in Examples;
FIG. 6 (A) shows a plan view illustrating a photo-electric power generating device according to a conventional example, and FIG. 6 (B) shows a cross sectional view taken in the direction of arrows B-B in FIG. 6 (A); and
FIG. 7 (A) shows a graph indicating the results of measurements of FF (fill factor) of each photo-electric power generating device of Example 7, and FIG. 4 (B) shows a graph indicating the results of measurements of Pmax (maximum output) of each photo-electric power generating device of Example 7.

### [Description of Embodiments]

In the following, embodiments for carrying out the present invention will be explained with reference to the attached drawings.

### First Embodiment

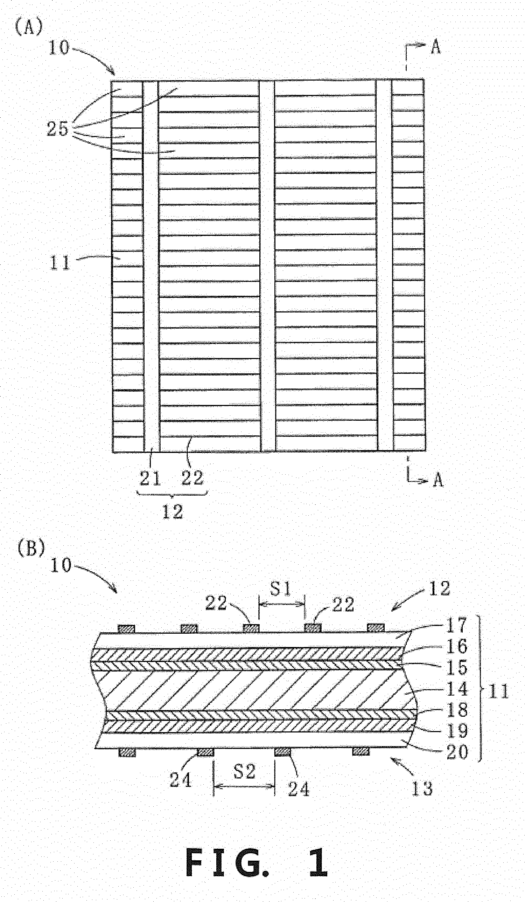

As shown in FIGs. 1 (A) and (B), the photo-electric power generating device 10 according to the first embodiment of the present invention includes a photo-electric power generating element 11, a first collector member 12, and a second collector member 13. The first collector member 12 is overlaid on one face of the photo-electric power generating element 11 (upper side in FIG. 1). The second collector member 13 is overlaid on other face of the photo-electric power generating element 11 (lower side in FIG. 1).

The photo-electric power generating element 11 has a multilayered and platy structure. The photo-electric power generating element 11 has: an n-type crystal semiconductor substrate 14; a first intrinsic amorphous silicon thin film 15, a p-type amorphous silicon thin film 16 and a first transparent conductive film 17 overlaid in this order on the side of the n-type crystal semiconductor substrate 14 on which the first collector member 12 is provided (upper side in FIG. 1); and a second intrinsic amorphous silicon thin film 18, an n-type amorphous silicon thin film 19 and a second transparent conductive film 20 overlaid in this order on the side of the n-type crystal semiconductor substrate 14 on which the second collector member 13 is provided (lower side in FIG. 1).

The n-type crystal semiconductor substrate 14 is not particularly limit as long as it is a crystal material having characteristics of n-type semiconductors, and a well-known n-type crystal semiconductor substrate may be used. As the n-type crystal semiconductor that constitutes the n-type crystal semiconductor substrate 14 is exemplified by silicon (Si), as well as SiC, SiGe, SiN and the like, and silicon is preferred in light of productivity, etc. The n-type crystal semiconductor substrate 14 may be either a monocrystal material, or a polycrystal material. The top and bottom (one face side and another face side) surfaces of the n-type crystal semiconductor substrate 14 preferably has protrusions and depressions through subjecting to a roughness treatment in order to achieve more effective light trapping by way of diffuse reflection of rays of light (not shown in the figure). It is to be noted that a large number of pyramidal protrusions and depressions can be formed through immersing the substrate material in an etching liquid containing, for example, about 1 to 5% by mass sodium hydroxide or potassium hydroxide.

The n-type crystal semiconductor substrate 14 is preferably produced by an epitaxy process. The epitaxy process is a method of forming an epitaxial layer by, for example, feeding a source gas on a crystal substrate. The formed epitaxial layer is separated from the crystal substrate, and can be suitably used as the n-type crystal semiconductor substrate 14. The n-type crystal semiconductor substrate 14 produced by an epitaxy process is advantageous in that: defects induced by oxygen are less likely to be generated; fewer impurities are involved; and a dopant can be contained at high reproducibility, as compared with substrates produced by a general Cz process or the like. Therefore, use of the n-type crystal semiconductor substrate 14 produced by an epitaxy process leads to an increase of the maximum output and the like of the photo-electric power generating device 10, and to an improvement of uniformity thereof. In other words, due to a small difference in resistivity between substrates, a large-scale production of the photo-electric power generating device 10 having desired output characteristics is facilitated. This effect is remarkably exhibited, in particular, when the side provided with the second collector member 13 serves as the plane of light incidence (rear-emitter type). On the other hand, when the n-type crystal semiconductor substrate 14 is produced by a Cz process, since the substrate is obtained through cutting the silicon crystal to give a desired thickness, loss of the silicon in the cutting occurs. The loss of the silicon becomes more marked as the thickness of the substrate is smaller. However, in the case of the epitaxy process, the n-type crystal semiconductor substrate 14 can be directly produced to have a desired thickness, without need of cutting, and therefore, the loss of the silicon does not occur, leading to a cost reduction.

The resistivity of the n-type crystal semiconductor substrate 14 is preferably no less than 0.5 Ωcm and no greater than 5 Ωcm, and more preferably no less than 1 Ωcm and no greater than 3 Ωcm. When the n-type crystal semiconductor substrate 14 having the resistivity falling within the above range is used, maximum output and the like can be increased. This effect is remarkable in the case of a rear-emitter type. When the resistivity is too small, the maximum output decreases resulting from a reduction of the bulk lifetime. When the resistivity is too great, the lateral resistance on the side where the n-type amorphous silicon thin film 19 is formed increases, whereby the fill factor is decreased. It is to be noted that control of the resistivity is facilitated by using the n-type crystal semiconductor substrate 14 produced by an epitaxy process.

The thickness (average thickness) of the n-type crystal semiconductor substrate 14 is preferably no less than 50 µm and no greater than 200 µm, and more preferably no less than 80 µm and no greater than 150 µm. When such a comparatively thin substrate is employed, an improvement of the output characteristics, and cost reduction can be both achieved while sufficient output characteristics are achieved.

The first intrinsic amorphous silicon thin film 15 is overlaid on the upper face of the n-type crystal semiconductor substrate 14. It is to be noted that the upper face and the lower face do not in any way restrict the top and bottom in use (the same applies to the following definition). The thickness of the first intrinsic amorphous silicon thin film 15 is not particularly limited, and may be, for example, no less than 1 nm and no greater than 10 nm. When the film thickness is less than 1 nm, recombination of the carrier is likely to occur due to an increased tendency to generation of defects, and the like. In addition, when the film thickness is greater than 10 nm, a decrease of the fill factor is likely to occur.

The first intrinsic amorphous silicon thin film 15 can be formed by a well-known method such as e.g., a chemical vapor deposition process (for example, plasma CVD process, etc.). In the case where a plasma CVD process is carried out, for example, a gas mixture of SiH₄ and H₂ may be used as a source gas.

In the case where a plasma CVD process is carried out, the frequency is, for example, about 13.56 MHz or about 40.68 MHz, and is more preferably about 40.68 MHz. The temperature in the formation is, for example, no less than 100 °C and less than 300 °C, and more preferably no less than 180 °C and less than 220 °C. The pressure in the reaction is no less than 5 Pa and less than 300 Pa, and more preferably no less than 50 Pa and less than 200 Pa. RF or VHF power is, for example, no less than about 1 mW/cm² and less than 500 mW/cm², and more preferably no less than about 5 mW/cm² and less than 100 mW/cm².

The p-type amorphous silicon thin film 16 is overlaid on the upper face of the first intrinsic amorphous silicon thin film 15. The thickness of the p-type amorphous silicon thin film 16 is less than 6 nm, more preferably no greater than 5 nm, and still more preferably no greater than 4 nm. In the photo-electric power generating device 10, by making the thickness of the p-type amorphous silicon thin film 16 smaller, and by specifying the shape (specifically, interval of finger electrodes) of the first collector member 12 on the side provided with the p-type amorphous silicon thin film 16 as described later, the fill factor and the efficiency of electric power generation can be improved. It is to be noted that the lower limit of the thickness of the p-type amorphous silicon thin film 16 may be, for example, 1 nm, preferably 2 nm, and more preferably 3 nm. When the film thickness is no less than 1 nm in order to mitigate the influence from band bending that occurs through bonding of the transparent conductive film and the p-type amorphous silicon thin film, Voc (open circuit voltage) can be further increased, and the fill factor can be further increased.

The p-type amorphous silicon thin film 16 can be also formed by a well-known method such as a chemical vapor deposition process (for example, plasma CVD process, etc.). In the case where a plasma CVD process is carried out, for example, a gas mixture of SiH₄, H₂ and B₂H₆ may be used as a source gas.

In the case where a plasma CVD process is carried out, the frequency is, for example, about 13.56 MHz or about 40.68 MHz, and is more preferably about 40.68 MHz. The temperature in the formation is, for example, no less than 100 °C and less than 300 °C, and more preferably no less than 130 °C and less than 200 °C. The pressure in the reaction is no less than 5 Pa and less than 300 Pa, and more preferably no less than 50 Pa and less than 200 Pa. RF or VHF power is, for example, no less than about 1 mW/cm² and less than 500 mW/cm², and more preferably no less than about 5 mW/cm² and less than 100 mW/cm².

The first transparent conductive film 17 is overlaid on the upper face of the p-type amorphous silicon thin film 16. Exemplary transparent electrode material that constitutes the first transparent conductive film 17 may include well-known materials such as e.g., indium tin oxide (ITO), tungsten-doped indium oxide (indium tungsten oxide: IWO), cerium-doped indium oxide (indium cerium oxide: ICO), IZO (indium zinc oxide), AZO (aluminum-doped ZnO), GZO (gallium-doped ZnO) and the like.

The film-forming method of the first transparent conductive film 17 is not particularly limited, and a well-known method such as, for example, a sputtering process, a vacuum deposition process and an ion plating process (reactive plasma vapor deposition process) can be employed, and an ion plating process is preferably employed. Formation through, for example, an ion plating process which does not generate high-energy particles enables deterioration of the surface of the p-type amorphous silicon thin film 16 to be inhibited. Accordingly, such a process enables use of the p-type amorphous silicon thin film 16 with favorable qualities maintained, and the fill factor can be further increased. In addition, by employing the ion plating process, the first transparent conductive film 17 having superior adhesiveness can be formed, which is considered to be the cause of an increase of the fill factor.

The second intrinsic amorphous silicon thin film 18 is overlaid on the lower face of the n-type crystal semiconductor substrate 14. Preferred film thickness and preferred film-forming method of the second intrinsic amorphous silicon thin film 18 are similar to those of the first intrinsic amorphous silicon thin film 15.

The n-type amorphous silicon thin film 19 is overlaid on the lower face of the second intrinsic amorphous silicon thin film 18. The thickness of the n-type amorphous silicon thin film 19 is not particularly limited, and is, for example, preferably no less than 1 nm and no greater than 20 nm, and more preferably no less than 3 nm and no greater than 10 nm. When the film thickness falls within such a range, a decrease of the short circuit current, and an occurrence of recombination of the carrier can be inhibited in a well-balanced manner. The n-type amorphous silicon thin film 19 can be formed also by a well-known method such as a chemical vapor deposition process (for example, plasma CVD process, etc.). In the case where a plasma CVD process is carried out, for example, a gas mixture of SiH₄, H₂ and PH₃ may be used as a source gas.

In the case where a plasma CVD process is carried out, the frequency is, for example, about 13.56 MHz or about 40.68 MHz, and is more preferably about 40.68 MHz. The temperature in the formation is, for example, no less than 100 °C and less than 300 °C, and more preferably no less than 180 °C and less than 220 °C. The pressure in the reaction is no less than 5 Pa and less than 300 Pa, and more preferably no less than 50 Pa and less than 200 Pa. RF or VHF power is, for example, no less than about 1 mW/cm² and less than 500 mW/cm², and more preferably no less than about 5 mW/cm² and less than 100 mW/cm².

The second transparent conductive film 20 is overlaid on the lower face of the n-type amorphous silicon thin film 19. Preferred material and preferred film-forming method of the second transparent conductive film 20 are similar to those of the first transparent conductive film 17.

It is to be noted that in the photo-electric power generating device 10, transparent conductive films 17, 20 are provided on both two faces of the photo-electric power generating element 11, respectively. In other words, a transparent conductive film is overlaid also on the side on which light incidence is obviated. Thus providing transparent electrode films 17, 20 between the p-type amorphous silicon thin film 16 or the n-type amorphous silicon thin film 19, and the collector members 12, 13, respectively, enables an increase of the interfacial level to be prevented, and the fill factor can be increased.

The first collector member 12 is overlaid on the upper face of the photo-electric power generating element 11, in other words, is overlaid on the upper face of the first transparent conductive film 17. The first collector member 12 is connected to a plurality of busbar electrodes (I) 21 formed to be parallel with each other, and a plurality of finger electrodes (I) 22 connected to the busbar electrode (I) 21 and formed to be parallel with each other.

The plurality of busbar electrodes (I) 21 are arranged at regular intervals. In addition, the busbar electrodes (I) 21 are linear or strip-shaped, and formed from an electrically conductive material. As the electrically conductive material: an electrically conductive adhesive such as a silver paste; a metal lead wire such as a copper wire; or a combination of the electrically conductive adhesive and the metal lead wire may be used. The metal lead wire can be fixed on the first transparent conductive film 17 by using an electrically conductive or electrically nonconductive adhesive for fixation, or a metal having a low melting point (solder, etc.). Also, when an electrically conductive adhesive is used, the busbar electrode (I) 21 may be formed by a printing technique such as screen printing or gravure off-set lithography. When the number of the busbar electrodes (I) 21 is 3 to 5, the width of each busbar electrode (I) 21 is, for example, about no less than 0.5 mm and no greater than 2 mm. Alternatively, when the number of busbar electrodes (I) 21 is no less than 10, a wire having a diameter of about 0.1 mm may be also used.

The finger electrodes (I) 22 are linear, and formed from an electrically conductive material. The finger electrode (I) 22 is provided to be orthogonal to the busbar electrode (I) 21. Also, the plurality of finger electrodes (I) 22 are provided at regular intervals. The electrically conductive material for forming the finger electrode (I) 22 may be similar to the material that constitutes the busbar electrode (I) 21. When the busbar electrode (I) 21 and the finger electrode (I) 22 are both formed from an electrically conductive adhesive, they can be overlaid on one face of the first transparent conductive film 17 at the same time by printing. The width of each finger electrode (I) 22 is, for example, about no less than 10 µm and no greater than 300 µm, and preferably no less than 30 µm and no greater than 200 µm.

An interval (S1) between adjacent finger electrodes (I) 22 is less than 2 mm, and preferably no greater than 1.5 mm. It is to be noted that in the first embodiment, each region comparted by the first collector member 12 (the busbar electrodes (I) 21 and the finger electrodes (I) 22) corresponds to a nonoverlaid region 25 of the first collector member 12 on the surface of the first transparent conductive film 17 (the photo-electric power generating element 11). The surface of the first transparent conductive film 17 (photo-electric power generating element 11) as referred to means a side on which the first collector member 12 is overlaid. In addition, each nonoverlaid region 25 has a rectangular shape (strip-like shape), the longitudinal direction of which corresponding to the longitudinal direction of the finger electrode (I) 22. In other words, the interval (S1) of the finger electrodes (I) 22 corresponds to the maximum width of the nonoverlaid region 25 of the first collector member 12 on the surface of the first transparent conductive film 17. According to the photo-electric power generating device 10, by thus narrowing, with respect to pn-junctions, the interval (S1) of the finger electrodes (I) 22 on the side provided with the p-type amorphous silicon thin film 16 to be less than 2 mm, the fill factor is increased, and thus the efficiency of electric power generation can be enhanced. The lower limit of the interval (S1) of the finger electrode (I) 22 is not particularly limited; however, the lower limit is, for example, 0.1 mm, and more preferably 0.5 mm. When the interval (S1) of the finger electrode (I) 22 on the side provided with the p-type amorphous silicon thin film 16 is no less than 0.1 mm, it is also possible, for example, to satisfactorily use as a plane of light incidence also the side provided with the first collector member 12, to reduce the amount of the electrically conductive material used for forming the finger electrode (I) 22, and the like.

The second collector member 13 is provided on the lower face of the photo-electric power generating element 11, i.e., the surface of the second transparent conductive film 20. The second collector member 13 has a plurality of busbar electrodes (II) formed to be parallel with each other (not shown in the figure), and a plurality of finger electrodes (II) 24 connected perpendicularly to the busbar electrodes (II) and formed to be parallel with each other.

The shape, the material, the size, the forming method and the like of the busbar electrode (II) of the second collector member 13 are similar to those of the busbar electrode (I) 21 of the first collector member 12.

The shape, the material, the size, the forming method and the like of the finger electrode (II) 24 are also similar to those of the finger electrode (I) 22 of the first collector member 12. However, the interval (S2) between adjacent finger electrodes (II) 24 is not particularly limited. The interval (S2) may be, for example, no less than 0.5 mm and no greater than 4 mm, preferably no less than 1 mm, more preferably no less than 2 mm, and particularly preferably greater than 2 mm. Moreover, the interval (S2) is preferably no greater than 3 mm, more preferably less than 3 mm, and particularly preferably no greater than 2.5 mm. By thus increasing the interval (S2) of the finger electrode (II) 24 on the side provided with the n-type amorphous silicon thin film 19, for example, it is possible to suitably use as a plane of light incidence the side provided with the second collector member 13, to reduce the amount of the electrically conductive material used for forming the finger electrode (II) 24, and the like.

The photo-electric power generating device 10 having such a structure is typically used through connecting a plurality of the same in series. By using a plurality of photo-electric power generating devices 10 through connecting in series, the generated voltage can be increased.

According to the photo-electric power generating device 10, as explained above, by making the thickness of the p-type amorphous silicon thin film 16 as small as less than 6 nm, and by narrowing the interval (S1) of the finger electrode (I) 22, i.e., the maximum width of the nonoverlaid region 25 of the first collector member 12 on the surface of the first transparent conductive film 17 to be less than 2 mm, the fill factor is increased, and thus the efficiency of electric power generation can be enhanced. In the photo-electric power generating device 10, the plane of light incidence may be either one face, and the side provided with the second collector member 13 may be employed as the plane of light incidence. As described above, with respect to the finger electrodes (II) 24, the interval (S2) can be sufficiently increased, such that the light blocking effect is impaired. Accordingly, the efficiency of electric power generation of the photo-electric power generating device 10 can be further enhanced through adopting such a configuration. Furthermore, in the photo-electric power generating device 10, the p-type amorphous silicon thin film 16 has a smaller thickness, and the side provided with the first collector member 12 can be also used as a plane of light incidence.

### Second Embodiment

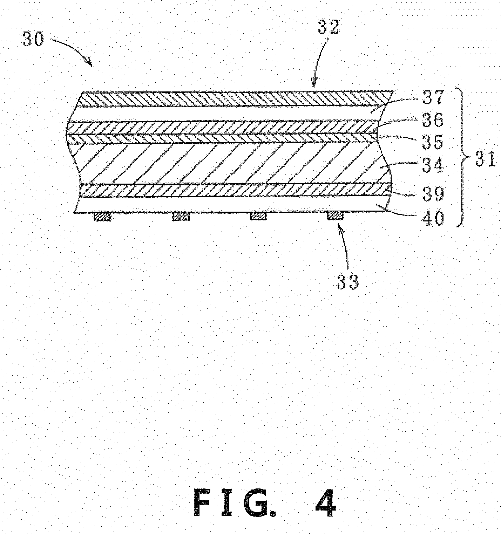

As shown in FIG. 4, a photo-electric power generating device 30 according to the second embodiment of the present invention has: a photo-electric power generating element 31; and a first collector member 32 and a second collector member 33 overlaid on the upper face and the lower face of the photo-electric power generating element 31, respectively. The photo-electric power generating element 31 is a layer structure that includes: an n-type crystal semiconductor substrate 34; a first intrinsic amorphous silicon thin film 35, a p-type amorphous silicon thin film 36 and a first transparent conductive film 37 overlaid in this order on the side of the n-type crystal semiconductor substrate 34 on which the first collector member 32 is provided; and an n-type amorphous silicon thin film 39 and a second transparent conductive film 40 overlaid in this order on the side of the n-type crystal semiconductor substrate 34 provided with the second collector member 33. The photo-electric power generating element 31 is similar to the photo-electric power generating element 11 shown in FIG. 1 except that the second intrinsic amorphous silicon thin film is not provided. More specifically, the shape, the material, the film-forming method and the like of the n-type crystal semiconductor substrate 34, the first intrinsic amorphous silicon thin film 35, the p-type amorphous silicon thin film 36, the first transparent conductive film 37, the n-type amorphous silicon thin film 39 and the second transparent conductive film 40 are similar to those of the n-type crystal semiconductor substrate 14, the first intrinsic amorphous silicon thin film 15, the p-type amorphous silicon thin film 16, the first transparent conductive film 17, the n-type amorphous silicon thin film 19 and the second transparent conductive film 20, respectively, shown in FIG. 1, and therefore, detailed description is omitted here.

The photo-electric power generating device 30 has a structure in which the n-type crystal semiconductor substrate 34 and the n-type amorphous silicon thin film 39 are directly bonded. Accordingly, a sufficient fill factor can be attained even if the second intrinsic amorphous silicon thin film is not overlaid between the n-type crystal semiconductor substrate 34 and the n-type amorphous silicon thin film 39.

The first collector member 32 overlaid on the upper face of the photo-electric power generating element 31 (surface of the first transparent conductive film 37) is a metal film. This metal film (first collector member 32) is overlaid substantially on the entire face. More specifically, the maximum width of the nonoverlaid region of first collector member 32 on the surface of the first transparent conductive film 37 (face on the side on which the first collector member 32 is overlaid) is 0 mm (nonoverlaid region being absent). Accordingly, the electric conductivity, and in turn, the current collection efficiency, of the first collector member 32 can be further enhanced. Moreover, in this instance, the metal film can be formed by a thin film-forming method such as PVD or CVD. Since the electrical conductivity of the metal film obtained by the thin film-forming method is greater, in general, as compared with the electrical conductivity attained by a printing method, consequently a decrease of the amount of the metal material used for forming the metal film (first collector member 32) is also enabled. This metal film can be formed from a well-known metal such as Ag, Al, Cu, Ni and Cr, or the like, and the metal film can be also formed from an alloy that contains at least one type of these metals. Structures obtained by overlaying further a variety of metals may be employed. Ag is preferably used for the metal film. The thickness of the metal film may be, for example, no less than 100 nm and no greater than 1,000 nm, and the thickness is more preferably less than 500 nm for achieving cost reduction. The metal film is preferably formed by a vacuum deposition process, a sputtering process, or the like.

The second collector member 33 overlaid on the lower face (surface of the second transparent conductive film 40) of the photo-electric power generating element 31 has a structure that includes busbar electrodes and finger electrodes. Since the shape, the material, the size, the forming method and the like of the second collector member 33 are similar to those of the second collector member 13 shown in FIG. 1, the description thereof is omitted. In the photo-electric power generating element 31, the side provided with the second collector member 33 serves as a plane of light incidence.

### Other Embodiments

The present invention is by no means limited to the aforementioned embodiments, and any modification can be made to the embodiments described above without departing from the spirit of the present invention. For example, in the photo-electric power generating device having a structure shown in FIG. 1, the second collector member may be not a structure that includes busbar electrodes and finger electrodes but a structure consisting of a metal film provided by overlaying an electrically conductive material substantially on the entire face. The electrically conductive material for forming the metal film is exemplified by well-known metals such as Ag, Al, Cu, Ni and Cr, and alloys of these; however, Ag that exhibits a high reflectance at wavelengths in an infrared region is preferably used. The thickness of the metal film may be, for example, no less than 100 nm and no greater than 1,000 nm, and the thickness is more preferably less than 500 nm for achieving cost reduction. The metal film is preferably formed by a vacuum deposition process, a sputtering process, or the like. Accordingly, the current collection efficiency of the side provided with the second collector member can be increased. In this case, the side provided with the first collector member is employed as the plane of light incidence.

In addition, the structure of the first collector member is not particularly limited as long as the maximum width of the nonoverlaid region is less than 2 mm. For example, the first collector member may be a metal film that includes pores having a diameter of less than 2 mm, or may consist of only busbar electrodes arranged with the interval of less than 2 mm.

### [EXAMPLES]

Hereinafter, the present invention will be more specifically explained by way of Examples and Comparative Examples. It should be noted that the present invention is not in any how limited to the following Examples.

### Examples 1 to 3, and Comparative Examples 1, 2

On one face side of an n-type monocrystal silicon substrate produced by a Cz process, a first intrinsic amorphous silicon thin film, a p-type amorphous silicon thin film and a first transparent conductive film were overlaid in this order. The first intrinsic amorphous silicon thin film was formed by a chemical vapor deposition process to give a film thickness of 7 nm, and the p-type amorphous silicon thin film was formed by a chemical vapor deposition process to give a film thickness of 5 nm, whereas the first transparent conductive film was formed by an ion plating process.

In addition, a second intrinsic amorphous silicon thin film, an n-type amorphous silicon thin film and a second transparent conductive film were overlaid in this order on other side of the n-type monocrystal silicon substrate. The second intrinsic amorphous silicon thin film was formed by a chemical vapor deposition process to give a film thickness of 7 nm, the n-type amorphous silicon thin film was formed by a chemical vapor deposition process to give a film thickness of 5 nm, whereas the second transparent conductive film was formed by an ion plating process. As the transparent electrode material for forming the first and second transparent conductive films, IWO was used.

On both two faces of the photo-electric power generating element obtained in this manner, as a collector member, a plurality of parallel busbar electrodes, and a plurality of finger electrodes each orthogonal to the busbar electrodes were formed, respectively. The collector member was formed by printing with use of a silver paste. It is to be noted that the interval of the finger electrodes (I) on the side provided with the p-type amorphous silicon thin film, and the interval of the finger electrodes (II) on the side provided with the n-type amorphous silicon thin film were as in the following, respectively. Thus, the photo-electric power generating devices of Examples 1 to 3 and Comparative Examples 1, 2 were obtained. The width of the finger electrodes was no less than 50 µm and less than 100 µm.

### Comparative Example 1

Interval of the finger electrodes (I) on the side provided with the p-type amorphous silicon thin film: 2 mm
Interval of the finger electrodes (II) on the side provided with the n-type amorphous silicon thin film: 2 mm

### Comparative Example 2

Interval of the finger electrodes (I) on the side provided with the p-type amorphous silicon thin film: 2 mm
Interval of the finger electrodes (II) on the side provided with the n-type amorphous silicon thin film: 1.5 mm

### Example 1

Interval of the finger electrodes (I) on the side provided with the p-type amorphous silicon thin film: 1.5 mm
Interval of the finger electrodes (II) on the side provided with the n-type amorphous silicon thin film: 2 mm

### Example 2

Interval of the finger electrodes (I) on the side provided with the p-type amorphous silicon thin film: 1.5 mm
Interval of the finger electrodes (II) on the side provided with the n-type amorphous silicon thin film: 2.5 mm

### Example 3

Interval of the finger electrodes (I) on the side provided with the p-type amorphous silicon thin film: 1.5 mm
Interval of the finger electrodes (II) on the side provided with the n-type amorphous silicon thin film: 3.0 mm

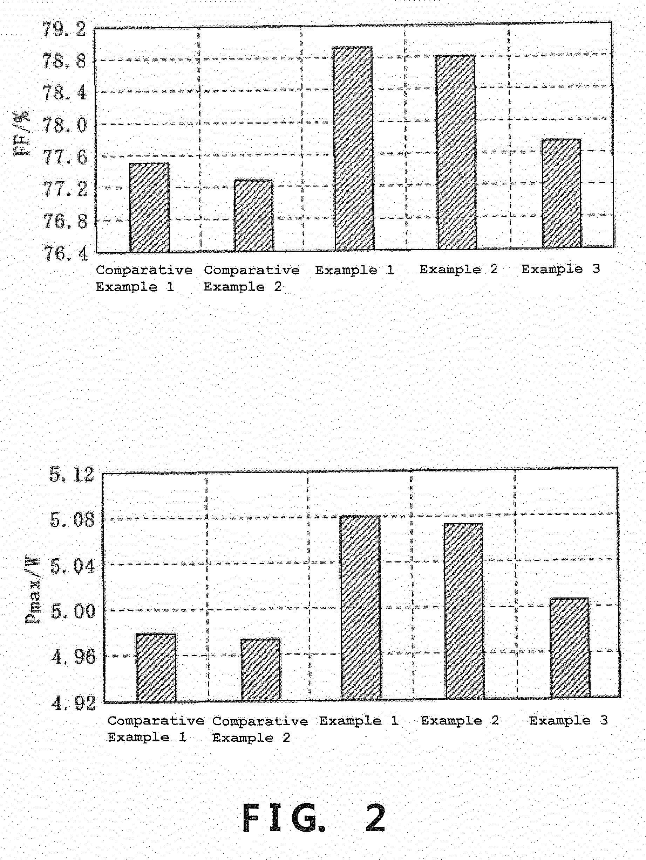

The fill factor (FF) and the maximum output (Pmax) of each photo-electric power generating device obtained were measured. It is to be noted that the side provided with the p-type amorphous silicon thin film (side provided with the first collector member) was employed as a plane of light incidence. Furthermore, the area of a part on the side of the plane of light incidence where the first collector member was not overlaid (part where light enters) was adjusted to be identical. More specifically, in screens used for the printing, the interval of the finger electrodes, and the width of the finger electrodes were regulated such that the area of light incidence was identical. The measurement results are shown in FIG. 2. It is proven that: even if the interval of the finger electrodes (II) on the side provided with the n-type amorphous silicon thin film is decreased, the fill factor and the like are not improved; when the interval of the finger electrodes (I) on the side provided with the p-type amorphous silicon thin film is adjusted to be less than 2 mm, the fill factor and the like are improved; and even if the interval of the finger electrodes (II) on the side provided with the n-type amorphous silicon thin film is increased, the fill factor and the like are not significantly decreased.

### Example 4

A photo-electric power generating device of Example 4 was obtained in a similar manner to Example 1 and the like except that the interval of the finger electrodes (I) on the side provided with the p-type amorphous silicon thin film, the interval of the finger electrodes (II) on the side provided with the n-type amorphous silicon thin film, and the thickness of the p-type amorphous silicon thin film were as in the following.
Interval of the finger electrodes (I) on the side provided with the p-type amorphous silicon thin film: 1 mm
Interval of the finger electrodes (II) on the side provided with the n-type amorphous silicon thin film: 2 mm
Thickness of the p-type amorphous silicon thin film (p layer thickness): altered between 1 nm to 8 nm. Note that the thickness of the p-type amorphous silicon thin film falling within the range of no less than 6 nm was employed in Comparative Examples.

### Example 5

A photo-electric power generating device of Example 5 (photo-electric power generating device having a structure shown in FIG. 4) was obtained in a similar manner to Example 1 and the like except that: a metal film of Ag formed by a vacuum deposition process so as to have a thickness of 100 nm and to cover substantially the entire face of the surface was employed as the first collector member on the side provided with the p-type amorphous silicon thin film; the interval of the finger electrodes (II) on the side provided with the n-type amorphous silicon thin film, and the thickness of the p-type amorphous silicon thin film were as in the following; and the intrinsic amorphous silicon thin film was not overlaid on the side provided with the n-type amorphous silicon thin film.
Interval of the finger electrodes (II) on the side provided with the n-type amorphous silicon thin film: 2 mm
Thickness of the p-type amorphous silicon thin film (p layer thickness): altered between 1 nm to 8 nm.
Note that the thickness of the p-type amorphous silicon thin film falling within the range of no less than 6 nm was employed in Comparative Examples.

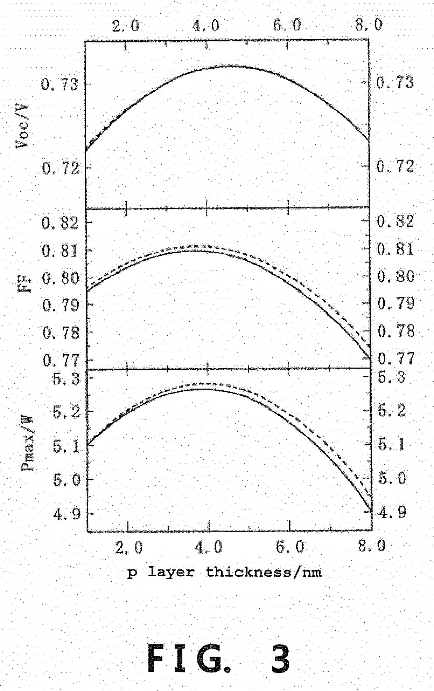

The open circuit voltage (V_{OC}), the fill factor (FF) and the maximum output (Pmax) of the photo-electric power generating devices obtained in Example 4 and Example 5 were measured. It is to be noted that the side provided with the n-type amorphous silicon thin film (side provided with the second collector member) was employed as a plane of light incidence. The measurement results are shown in FIG. 3. It is to be noted that in FIG. 3, the solid line indicates Example 4, whereas the dotted line indicates Example 5. It is proven that: the thickness of the p-type amorphous silicon thin film being less than 6 nm allows a high fill factor and maximum output to be attained; and employing as the first collector member on the side provided with the p-type amorphous silicon thin film, the metal layer of Ag formed by a vacuum deposition process so as to have a thickness of 100 nm allows a still higher fill factor and maximum output to be attained.

In order to study the effects of the invention in detail, each test film as follows was produced, and the sheet resistance was measured by a four-terminal resistance measuring method.

### Comparative Example 3

An IWO film (100 nm) was formed by using an ion plating process on a smooth glass substrate not subjected to a protrusions-and-depressions forming processing for optical confinement.

### Comparative Example 4

An i-type amorphous silicon thin film (7 nm) and a p-type amorphous silicon thin film (5 nm) by using a CVD process, and an IWO film (100 nm) by using an ion plating process were formed in this order on a smooth glass substrate not subjected to a protrusions-and-depressions forming processing for optical confinement.

### Comparative Example 5

An i-type amorphous silicon thin film (7 nm) and an n-type amorphous silicon thin film (5 nm) by using a CVD process, and an IWO film (100 nm) by using an ion plating process were formed in this order on a smooth glass substrate not subjected to a protrusions-and-depressions forming processing for optical confinement.

### Comparative Example 6

An IWO film (100 nm) was formed by using an ion plating process on a smooth n-type monocrystal silicon substrate (200 µm, 1 to 2 Ωcm) not subjected to a protrusions-and-depressions forming processing for optical confinement.

### Comparative Example 7

An i-type amorphous silicon thin film (7 nm) and a p-type amorphous silicon thin film (5 nm) by using a CVD process, and an IWO film (100 nm) by using an ion plating process were formed in this order on a smooth n-type monocrystal silicon substrate (200 µm, 1 to 2 Ωcm) not subjected to a protrusions-and-depressions forming processing for optical confinement.

### Reference Example 1

An i-type amorphous silicon thin film (7 nm) and an n-type amorphous silicon thin film (5 nm) by using a CVD process, and an IWO film (100 nm) by using an ion plating process were formed in this order on a smooth n-type monocrystal silicon substrate (200 µm, 1 to 2 Ωcm) not subjected to a protrusions-and-depressions forming processing for optical confinement.

The measurement results of the sheet resistance on each test film are shown in Table 1.

**Table 1**

| Test film | Sheet resistance (Ω/□) |
|---|---|
| Comparative Example 3 | 27.5 |
| Comparative Example 4 | 28.0 |
| Comparative Example 5 | 27.4 |
| Comparative Example 6 | 27.3 |
| Comparative Example 7 | 27.1 |
| Reference Example 1 | 15.0 |

As shown in Table 1, it was ascertained that the sheet resistance of Reference Example 1 was lower to approximately half, as compared with those of Comparative Examples 3 to 7. Since the resistance was low only in the case of Reference Example 1, it is suggested that an n-channel was formed at heterojunctions between the n-type monocrystal silicon substrate and the n-type amorphous silicon thin film.

In addition, the results shown in Table 1 suggest that the lateral resistance on the side of the face on which the p-type amorphous silicon thin film was formed was decided depending on the transparent conductive film. In this regard, provided that, for example, the volume resistance of the transparent conductive film on the side of the face on which the p-type amorphous silicon thin film was formed is less than 1.5 * 10⁻⁴ Ωcm, it is expected that an effect equivalent to the improvement of the fill factor resulting from the interval of the finger electrodes on the side of the face on which the p-type amorphous silicon thin film is formed adjusted to be less than 2 mm in the present invention would be achieved. However, an improvement of the carrier density leads to an increase of absorption loss of light in transparent conductive films. Therefore, it is impossible to attain a maximum output because of deterioration of electric current characteristics, unless only the mobility is improved while making a carrier density lower; however, a drastic improvement of only the mobility in such a manner would be difficult. In addition, the lateral resistance can be reduced also when the transparent conductive film on the side of the face on which the p-type amorphous silicon thin film is formed is thickened. However, the transparent conductive film serving as a plane of light incidence is effective in improving electric current characteristics when the film thickness is selected that leads to a reflectance at 400 to 600 nm in which the spectrum strength of sunlight is intensive, and therefore, for example, an increase of the thickness of the transparent conductive film by only about 10 nm is acceptable. Thus, it is difficult to drastically reduce the lateral resistance. In addition, also on the transparent conductive film that is on the opposite side to the plane of light incidence, for example, photons of 900 to 1,200 nm that failed to be absorbed in the monocrystal silicon substrate and reached the opposite side can reflect on the collector member on the other side, and can enter again from the other side so as to be capable of contributing to the electric power generation. However, in proportion to an increase of the thickness of the transparent conductive film on the opposite side, absorption loss in the transparent conductive film increases. Still further, an increase of the thickness of the transparent conductive film is not preferred also in light of the productivity and the reduction of cost. Therefore, an increase of the fill factor through a decrease of the interval of the finger electrodes formed on the side provided with the p-type amorphous silicon thin film is preferred in any of the viewpoints involving the performance, productivity and cost reduction, than an increase of the fill factor through a decrease of the resistance of the transparent conductive film.

### Example 6

A photo-electric power generating element of Example 6 was obtained in a similar manner to Example 5 except that an n-type monocrystal silicon substrate (thickness: 150 µm) produced by epitaxy process was used, and a thermal donor killer annealing step subjected to the substrate was omitted. It is to be noted that the thickness of the p-type amorphous silicon thin film was 5 nm. The thermal donor killer annealing step as referred to means a procedure of removing a thermal donor in the n-type monocrystal silicon substrate, and is particularly important in heterojunction elements produced according to a low-temperature process. In other Examples and Comparative Examples in which the n-type monocrystal silicon substrate produced by a Cz process was used, the thermal donor killer annealing step was carried out. By omitting this step, a reduction of the manufacturing cost can be enhanced. The photo-electric power generating element of Example 6 obtained had a maximum output (Pmax) of 5.27 W, and a fill factor (FF) of 81%.

### Example 7

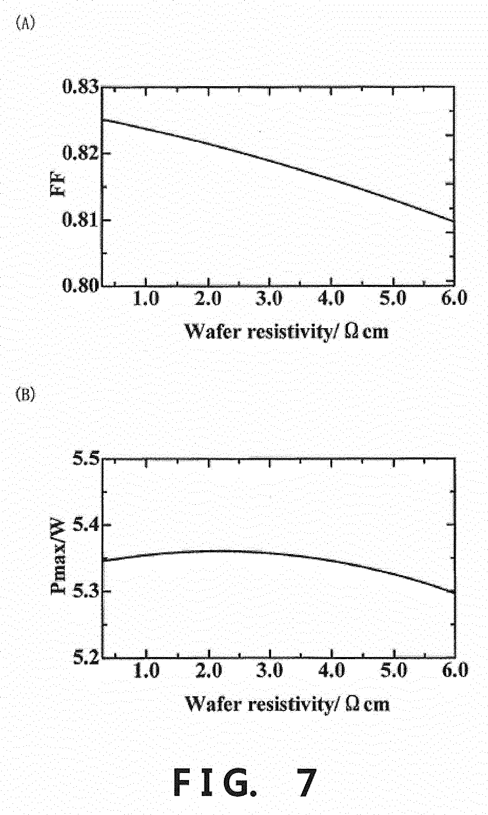

A photo-electric power generating element was obtained by a similar method to Example 5 using an n-type monocrystal silicon substrate having a resistivity of 0.3 to 6 Ωcm (Cz process). It is to be noted that the thickness of the p-type amorphous silicon thin film was 5 nm. Measurement results of FF (fill factor) and Pmax (maximum output) of each photo-electric power generating element thus obtained are shown in FIGs. 7 (A) and (B). As shown in FIG. 7 (A), along with an increase of the resistivity, the effective lateral resistance on the side on which the n-layer amorphous silicon thin film is formed increases, and FF (fill factor) decreases. As shown in FIG. 7 (B), in light of Pmax (maximum output), since an advantage of an improvement of FF along with a decrease of the resistivity competes with a disadvantage of a reduction of the bulk lifetime, the resistivity preferably falls within the range of 0.5 to 5 Ωcm, and particularly preferably falls within the range of 1 to 3 Ωcm. Since epitaxial substrates are accompanied by extremely few oxygen defects, and the resistivity can be controlled only with the doping level, it is possible to adjust the resistivity so as to accurately fall within the preferred range.

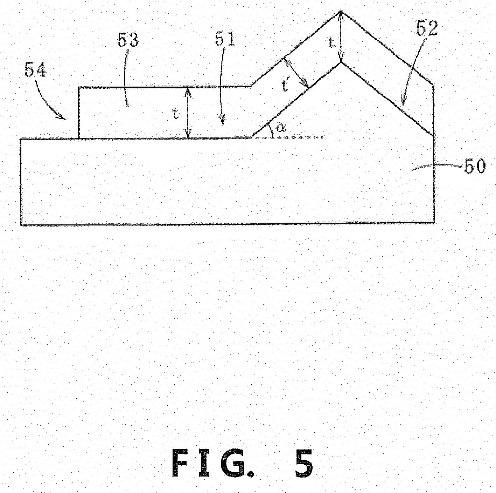

In this paragraph, the film thickness of each amorphous silicon thin film in Examples is explained. A virtual substrate 50 having both a smooth part 51 and a part having protrusions and depressions 52 is shown in FIG. 5. By using, for example, a transmission electron microscope (TEM), a thickness t perpendicular to the substrate 50, a thickness t' perpendicular to the plane, and an angle α in the part having protrusions and depressions 52 can be each measured. As referred to herein, the film thickness of an amorphous silicon thin film 53 overlaid on the smooth part 51 designates "t", whereas the film thickness of the amorphous silicon thin film 53 overlaid on the part having protrusions and depressions 52 designates "t'". In factual operations, a film thickness-evaluating method is preferably adopted which enables shortening of a measurement time period, and which uses a convenient surface profilometer or the like. The difference in level 54 is formed by, for example, wet-etching the amorphous silicon thin film 53 with a liquid prepared by heating KOH or NaOH to 40 to 50 °C, and "t" is measured according to the film thickness-evaluating method using the surface profilometer. Since an equality of t' = t * cosα is satisfied based on a trigonometrical function, calculation of t' would be possible from "t" thus measured. Since it was confirmed that t' obtained by the TEM measurement agrees with t' calculated according to the film thickness evaluation method using the surface profilometer, the film thickness-evaluating method using the surface profilometer was employed in the Examples. It is to be noted that the surface profilometer is an instrument for conducting a measurement through moving a probe upward and downward depending on the difference in level on a sample by horizontally tracing the surface with the probe to be contact with the sample, on the sample on which the difference in level was provided beforehand.

### [Explanation of the Reference Symbols]

- 10:: photo-electric power generating device
- 11:: photo-electric power generating element
- 12:: first collector member
- 13:: second collector member
- 14:: n-type crystal semiconductor substrate
- 15:: first intrinsic amorphous silicon thin film
- 16:: p-type amorphous silicon thin film
- 17:: first transparent conductive film
- 18:: second intrinsic amorphous silicon thin film
- 19:: n-type amorphous silicon thin film
- 20:: second transparent conductive film
- 21:: busbar electrode (I)
- 22:: finger electrode (I)
- 24:: finger electrode (II)
- 25:: nonoverlaid region
- 30:: photo-electric power generating device
- 31:: photo-electric power generating element
- 32:: first collector member
- 33:: second collector member
- 34:: n-type crystal semiconductor substrate
- 35:: first intrinsic amorphous silicon thin film
- 36:: p-type amorphous silicon thin film
- 37:: first transparent conductive film
- 39:: n-type amorphous silicon thin film
- 40:: second transparent conductive film
- 50:: substrate
- 51:: smooth part
- 52:: part having protrusions and depressions
- 53:: amorphous silicon thin film
- 54:: difference in level

## Claims

1. A photo-electric power generating device comprising:
a multilayered photo-electric power generating element; a first collector member overlaid on one face of the photo-electric power generating element; and a second collector member overlaid on other face of the photo-electric power generating element,
the photo-electric power generating element comprising: an n-type crystal semiconductor substrate; a first intrinsic amorphous silicon thin film, a p-type amorphous silicon thin film and a first transparent conductive film overlaid in this order on a side provided with the first collector member on the n-type crystal semiconductor substrate; and an n-type amorphous silicon thin film and a second transparent conductive film overlaid in this order on a side provided with the second collector member on the n-type crystal semiconductor substrate,
wherein,
the p-type amorphous silicon thin film has a thickness of less than 6 nm, and
a maximum width of a nonoverlaid region of the first collector member on a surface of the first transparent conductive film is less than 2 mm.

2. The photo-electric power generating device according to claim 1, wherein the first transparent conductive film is formed by an ion plating process.

3. The photo-electric power generating device according to claim 1 or 2, wherein the p-type amorphous silicon thin film has a thickness of no less than 1 nm.

4. The photo-electric power generating device according to any one of claims 1 to 3, wherein
the second collector member comprises a plurality of busbar electrodes (II) formed to be parallel with each other, and a plurality of finger electrodes (II) connected to the busbar electrode (II) and formed to be parallel with each other, and
an interval of the finger electrodes (II) is greater than 2 mm.

5. The photo-electric power generating device according to any one of claims 1 to 4, wherein
the first collector member comprises a plurality of busbar electrodes (I) formed to be parallel with each other, and a plurality of finger electrodes (I) connected to the busbar electrode (I) and formed to be parallel with each other, and
an interval of the finger electrode (I) is equivalent to the maximum width of the nonoverlaid region.

6. The photo-electric power generating device according to any one of claims 1 to 4, wherein the first collector member is a metal film.

7. The photo-electric power generating device according to claim 6, wherein the metal film has a thickness of no less than 100 nm and less than 500 nm.

8. The photo-electric power generating device according to any one of claims 1 to 7, wherein the side provided with the second collector member is employed as a plane of light incidence.

9. The photo-electric power generating device according to any one of claims 1 to 5, wherein the side provided with the first collector member is employed as a plane of light incidence.

10. The photo-electric power generating device according to any one of claims 1 to 9, further comprising a second intrinsic amorphous silicon thin film overlaid between the n-type crystal semiconductor substrate and the n-type amorphous silicon thin film.

11. The photo-electric power generating device according to any one of claims 1 to 10, wherein the n-type crystal semiconductor substrate is produced by an epitaxy process.

12. The photo-electric power generating device according to any one of claims 1 to 11, wherein a resistivity of the n-type crystal semiconductor substrate is no less than 0.5 Ωcm and no greater than 5 Ωcm.

13. The photo-electric power generating device according to any one of claims 1 to 12, wherein the n-type crystal semiconductor substrate has a thickness of no less than 50 µm and no greater than 200 µm.

14. The photo-electric power generating device according to claim 13, wherein the n-type crystal semiconductor substrate has a thickness of no less than 80 µm and no greater than 150 µm.
